# EUROPEAN PATENT SPECIFICATION

(11) **EP 0 409 245 B1**
(45) Date of publication and mention of the grant of the patent: **12.03.1997**
(21) Application number: 90113876.8
(22) Date of filing: 19.07.1990
(51) Int. Cl.: H01L 29/768, G11C 19/28

(54) **Charge transfer device provided with improved output structure**
Mit verbesserter Ausgangsstruktur ausgestattetes Ladungstransfer-Bauelement
Dispositif de transfert de charges muni d'une structure de sortie améliorée

(30) Priority: 21.07.1989 JP 190233/89
(43) Date of publication of application: 23.01.1991
(73) Proprietor: NEC CORPORATION, Tokyo (JP)
(72) Inventor: Miwada, Kazuo, Tokyo (JP)
(74) Representative: Glawe, Delfs, Moll & Partner

(56) References cited:
- EP-A- 0 096 166
- EP-A- 0 321 953
- FR-A- 2 606 553
- PATENT ABSTRACTS OF JAPAN vol. 8, no. 261 (E-281)(1698) 30 November 1984,& JP- A-59 132668 (TOSHIBA) 30 July 1984,
- PATENT ABSTRACTS OF JAPAN vol. 8, no. 268 (E-283)(1705) 07 December 1984,& JP-
- A-59 138376 (TOSHIBA) 08 August 1984,

## Description

The present invention relates to a solid-state charge transfer device such as a charge coupled device (CCD).

A floating diffused region is widely used as charge detecting means in a solid-state charge transfer device. In such a charge transfer device, a signal charge transferred through the channel region of a charge transfer section is led to the floating diffused region. After a quantity of charges transferred to the floating diffused region is converted into a voltage form signal to be outputted, the charges are drained to a reset drain through a channel under a reset gate.

The floating diffused region and the reset drain region are impurity-doped regions separately formed in a semiconductor substrate. The reset gate is provided on the semiconductor substrate between the floating diffused region and the reset drain region via an insulating layer. The floating diffused region, the reset gate electrode and the reset drain region constitute a field effect transistor (reset transistor).

The drain of charges from the floating diffused region is achieved by turning this reset transistor on. In order to accomplish this drain of charges, the potential of the reset drain should be higher than a certain level and held at that certain level. At the same time, the channel potential under the reset gate electrode in the aforementioned on-state of the reset transistor should be somewhat lower than that of the reset drain region. Because of these circumstances, the amplitude of the reset pulse to be applied to the reset gate electrode is usually greater than that of the transfer pulse of the charge transfer section. For instance, in an n-type buried channel charge coupled device, the amplitude of the transfer pulse is 5 volts; that of the reset pulse, 8 volts, and the voltage supplied to the reset drain region, 12 volts. Further in this example, when the reset pulse swings between 0 and 8 volts, the channel potential under the reset gate electrode changes between 7 volts and approximately 13.5 volts. As the channel potential (about 13.5 V) of a reset transistor in on-state is higher than the drain voltage, which is 12 volts, the reset transistor is driven into an on-state of a complete transfer mode to reset the potential of the floating diffused region to that of the reset drain region.

In a system using an image sensor of a charge coupled device, such as a facsimile system, the power voltage for the peripheral circuits using the output from the charge coupled device is as low as 5 volts, for instance, so that the charge coupled device operable at a low power voltage is widely demanded.

The drain voltage of 12 volts can be realized with relative ease with a voltage booster. However, a voltage booster for enhancing 5 volts of the reset pulse to 8 volts is more complex to provide than the aforementioned voltage booster from 5 volts to 15 volts and accordingly should one of circuits to be avoided in a semiconductor integrated circuit. On the other hand, if a reset pulse of 5 volts in amplitude is applied to the reset gate electrode, the channel potential of the reset transistor in on-state is about 11 volts in the above cited example, lower than the 12 volts in potential at the reset drain region. As a result, the reset transistor is driven into an on-state in an incomplete transfer mode. Under such incomplete transfer mode operation, it is impossible to completely drain the signal charges from the floating diffused region, and the dynamic range of the signal output will become correspondingly narrower.

Incidentally, the Japanese Patent laid-open Application No. 59-138376 discloses an output circuit for a charge coupled device operable at a low voltage supplied to the reset drain region. Two examples are disclosed therein. In the first example, first and second gates are arranged between the floating diffused region and the reset drain region. The first gate, similar to the charge transfer section, includes a pair of a barrier electrode and a storage electrode. The second gate is supplied with the same voltage as the output gate which is formed in adjacent to the floating diffused region in the charge transfer section, but the insulating film formed thereunder is thickened to keep the channel potential thereunder lower than the channel potential under the output gate. The charges in the floating diffused region, after being transferred to under the storage electrode of the first gate, are drained to the reset drain region. The first gate receives the same pulse as what is supplied to the output gate. In this way, the voltage supplied to the reset drain region can be lowered, because the potential at the reset drain region is sufficient to have a value slightly deeper than the channel potential under the storage electrode of the first gate when the channel potential takes a lower one. The transfer from the floating diffused region to under the storage electrode of the first gate is performed in an incomplete transfer mode, because the channel potential under the first barrier electrode is lower than that under the storage electrode.

In the second example, a third gate and an intermediate drain are arranged between the floating diffused region and the first gate in the first example, and a large-capacity capacitor is connected between the intermediate drain and the grounding terminal. The charges in the floating diffused region, after being first drained into this intermediate drain through the third gate, are finally drained into the reset drain held at a constant voltage. The transfer of charges from the floating diffused region to the reset drain is performed in a complete transfer mode. By supplying a different pulse to the second gate from that applied to the output gate, the potential at the reset drain can be further lowered. A pulse of a greater amplitude is required, however, when the charge under the storage electrode of the first gate is drained into the reset drain.

The potential at the reset drain, in both the first and the second examples, is made lower than the channel potential under the storage electrode.

As the potential at the reset drain bears on the formation of a transfer channel in a buried channel type charge coupled device, it may become necessary not only to lower the voltage to be applied to the reset drain but also to alter the impurity concentration in the channel layer and the peak voltage of the transfer pulse. Therefore, it is not necessarily advantageous to keep the reset drain voltage low.

A solid-state charge transfer device according to the preamble of claim 1 is disclosed in EP-A-0 096 166. This device comprises a series of spaced electrodes which are provided on a substrate between an output region and a drain region. A reset pulse is applied to the first electrode of the series and phase clock pulses are applied to intermediate electrodes of the series. A set pulse is applied to the last electrode. This structure extends the upper limit of the potential change of the output region.

It is an object of the invention to provide an electric charge transfer device capable of normal operation with a single low-voltage power source.

Another object of the invention is to provide an electric charge transfer device free from the deterioration of the dynamic range even if the amplitude of the reset pulse is equal to that of the transfer pulse.

These objects are achieved by a charge transfer device as defined in claim 1; the dependent claims are related to further developments of the invention.

In an electric charge transfer device according to the invention, an output gate is arranged as a final stage of a charge transfer section, and a floating diffused region is provided adjacent to the output gate. There is a reset gate electrode adjacent to the floating diffused region, and adjacent to the reset gate electrode is a reset drain region. A large-capacity capacitor is connected between the reset drain region and a reference potential terminal. Further, a barrier gate adjoins the reset drain region, and an absorption drain region is arranged next to the barrier gate. The barrier gate has a barrier gate electrode, provided on a semiconductor substrate via a gate insulating film, and the channel potential under the barrier gate electrode is lower than that of the reset gate electrode when in resetting operation. The preferred state of the means is realized by somewhat elongating the gate length of the barrier gate electrode when a reset gate electrode has a proper gate length to be accompanied by a short channel effect.

There further is a voltage booster inserted between the absorption drain region and an external terminal. This voltage booster can be readily realized with a circuit to enlarge the amplitude of the transfer pulse supplied to the charge transfer section.

The presence of the voltage booster makes it possible to sufficiently deepen the potential of the absorption drain region even if the voltage of the power source is low.

The charges in the floating diffused region are periodically drained, first temporarily to the reset drain region connected to the capacitor and then to the absorption drain connected to the voltage booster. As the large-capacity capacitor is connected to the reset drain region, its potential fluctuations can be ignored. The potential at the reset drain region can be deemed to be fixed at the channel potential under the barrier gate electrode. As the potential under the barrier gate electrode is set shallower than that under the reset gate electrode, the reset transistor consisting of the floating diffused region, the reset gate electrode and the reset drain region is driven into an on-state of a complete transfer mode. Signal charges remaining in the floating diffused region can be completely drained with a low-voltage power source.

The above-mentioned and other objects, features and advantages of the present invention will become more apparent by referring to the following detailed description of the invention taken in conjunction with the accompanying drawings, in which:
FIG. 1 gives a rough sectional view for describing the output circuit structure of an n-type buried channel charge coupled device according to a first preferred embodiment of the invention;
FIG. 2 is a graph illustrating the relationship between the channel potential and the gate voltage in the first preferred embodiment of the invention;
FIG. 3 is a circuit diagram illustrating the voltage booster using in the first embodiment;
FIG. 4 gives a rough sectional view and a potential diagram for use in describing the operation of the first embodiment; and
FIG. 5 gives a rough sectional view for describing the output circuit structure of an n-type buried channel charge coupled device according to the second preferred embodiment of the invention.

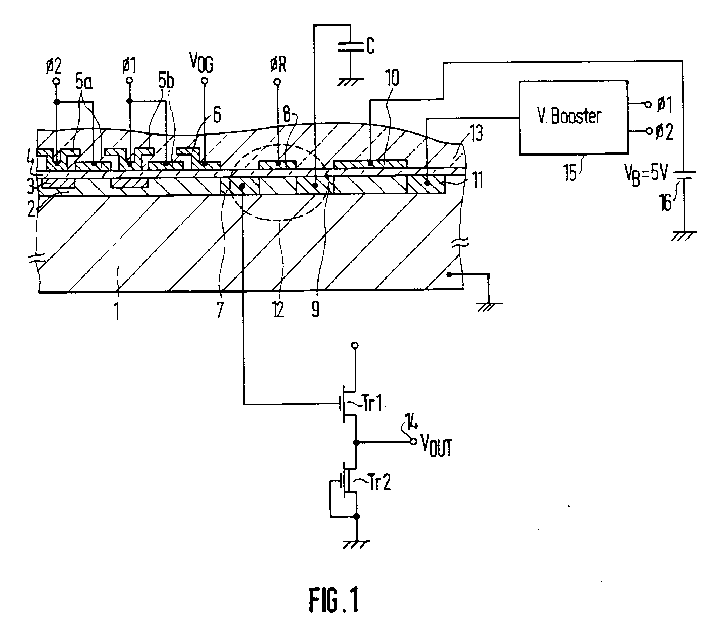

Referring to FIG. 1, in a first preferred embodiment of the present invention, an n-type diffused region 2 is formed over the surface of a p-type silicon substrate 1 whose impurity concentration is 5 x 10¹⁵ cm⁻³. The impurity concentration, thickness and width of the n-type diffused region 2 are 2 x 10¹⁶ cm⁻³, 1 micron meters and 10 micron meters, respectively. Over the surface of the silicon substrate 1 is provided a 100 nm thick gate oxide film 4, over which are arranged transfer electrodes 5a and 5b, an output gate electrode 6 and a reset gate electrode 8. These electrodes are made of phosphorus-doped polycrystalline silicon films of 400 nm in thickness and 20 Ω/□ in sheet resistance. Every one of them is 5 microns in width (gate length). In the n-type diffused region 2 (n-type buried channel) under the transfer electrodes are alternately formed p-type barrier regions 3 (1 x 10¹⁵ cm⁻³ in impurity concentration and at most 0.1 micron meters in thickness). The transfer electrode provided with one of the p-type barrier layers 3 is the barrier electrode, while that provided with none is the storage electrode. An n⁺-type floating diffused region 7 (2 x 10¹⁷ cm⁻³ in impurity concentration) is provided adjacent to a position immediately beneath the output gate electrode 6. The position immediately beneath the reset gate electrode 8 adjoins the floating diffused region 7 on one side and a reset drain 9 (an n⁺-type diffused region of 2 x 10¹⁷ cm⁻³ in impurity concentration) on the other.

To adjacent pairs of transfer electrodes 5a and 5b are respectively supplied transfer clocks φ₁ and φ₂, which are 5 V at the high level and 0 V at the low level and 180° apart in phase from each other. A fixed gate voltage V_{OG} (3 V for example) is applied to the output gate electrode 6 to control the flow of charges from the charge transfer section into the floating diffused region 7. To the reset electrode 8 is supplied a reset clock φ_{R}, which is the same as the clock φ₁ in phase, but shorter than the clock φ₁ in high level duration, 5 V at the high level and 0 V at the level, to reset the potential of the floating diffused region 7 to that of the reset drain region 9 at regular intervals by draining charges in the floating diffused region 7 to the reset drain region 9. The floating diffused region 7 is connected to the gate electrode of an enhancement type n channel MOS transistor Tr1 in a source follower circuit, which consists of the transistor Tr1 and a depression type n channel MOS transistor Tr2.

Further in the first embodiment, the reset drain 9 is grounded via a capacitor C, whose capacity is 100 to 1,000 times as great as that of the capacity (for instance 0.01 pF) of the floating diffused region 7, 5 pF for example. A barrier gate electrode 10 (phosphorus-doped polycrystalline silicon film) of 10 micron meters in gate length is provided via the gate oxide film 4 over the n-type diffused region 2 adjoining the reset drain region 9, and connected to an external power source 16. Adjacent to the n-type diffused region 2 beneath the barrier gate electrode 10, there is arranged an absorption drain region 11 (an n⁺-type diffused region of 2 x 10¹⁷ cm⁻³ in impurity concentration), to which a potential of 12 V is supplied by a voltage booster 15.

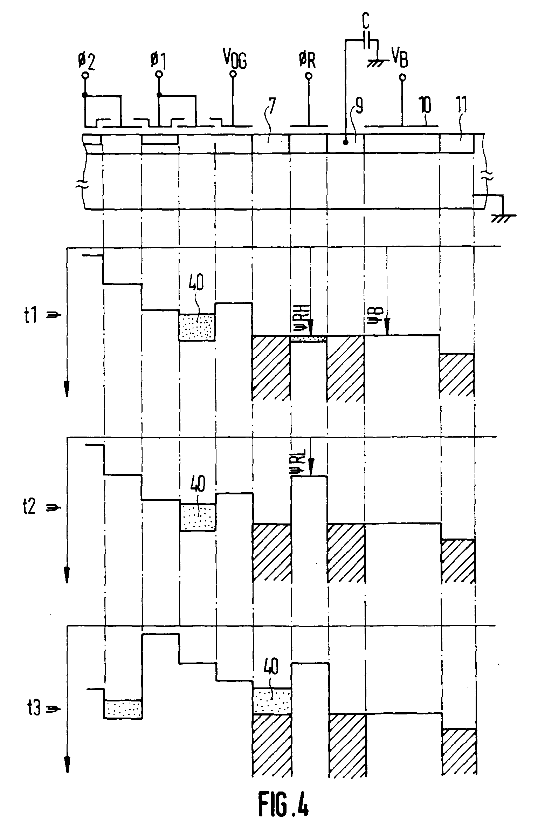

Referring now to FIG. 3, MOS transistors M₁, M₂, ...., M₈ are connected in cascade in the voltage booster 15. These MOS transistors have a common gate oxide film of 100 microns in the thickness and source/drain regions of 2 x 10¹⁷ cm⁻³ in impurity concentration and present a threshold voltage of 0.7 volts. The MOS transistors M₁ to M₈ are formed on the same semiconductor chip as the n-type buried channel charge coupled device.

The gate of the MOS transistor M₁ is supplied with the transfer clock φ₁. The transfer clock φ₁ is also supplied to the output side of the MOS transistors M₂, M₄, M₆ and M₈ through capacitors C₂, C₄, C₆ and C₈. To the output side of the MOS transistors M₁, M₃, M₅ and M₇ is supplied the transfer clock φ₂ through capacitors C₁, C₃, C₅ and C₇. The capacities of the capacitors C₁, C₂, ... C₈ are 3 pF each. Thus, the voltage booster uses diode-connected MOS transistors instead of diodes in an eightfold voltage doubler circuit. The use of the transfer clocks φ₁ and φ₂, both 5 V in amplitude, gives a D.C. voltage of about 12 V. The number of stages is increased, due to the inability of this circuit compared to a circuit using diodes on account of the back gate effect of the MOS transistors, to achieve an efficient boosting.

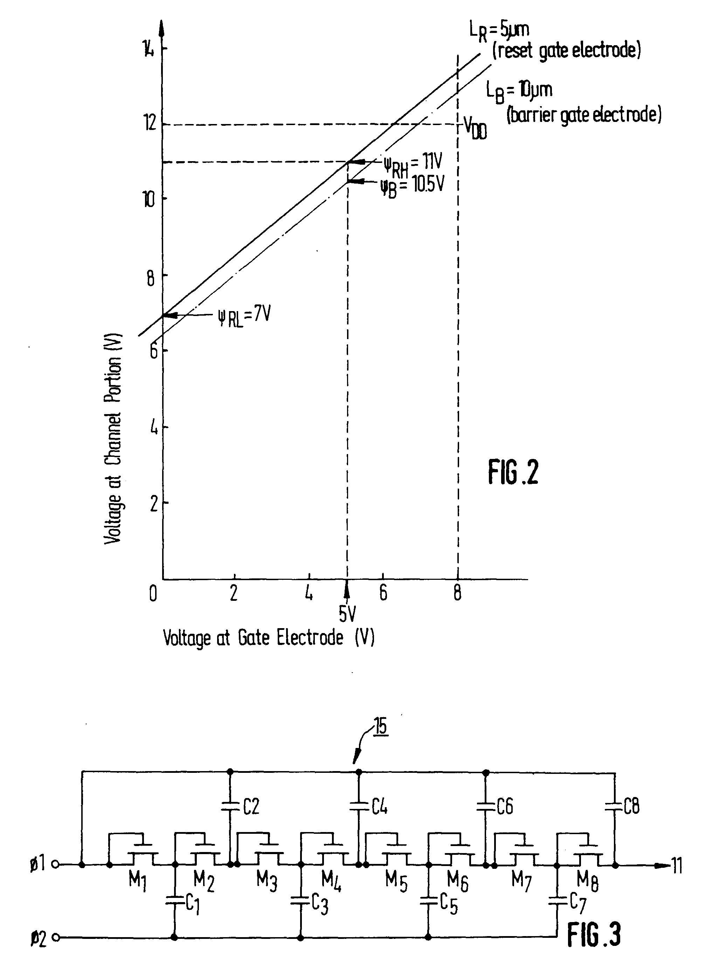

In the output circuit of FIG. 1, the gate lengths L_{R} and L_{B} of the reset gate electrode and the barrier gate electrode are 5 micron meters and 10 micron meters, respectively. Referring to FIG. 2, when 5 volts is applied to the reset gate electrode 8, the channel potential Ψ_{RH} beneath that gate electrode will become 11 V, and the channel potential Ψ_{B} beneath the barrier gate electrode held at a constant voltage of 5 volts will be fixed at 10.5 V. The difference in channel potential underneath, in spite of the same voltage supplied to the gate electrodes, is due to the short channel effect (which poses a problem from a gate length of around 7 microns on).

Incidentally, as a higher voltage (12 V) is applied to the absorption drain region 11, the potential at the reset drain region 9 is equal to the channel potential (Ψ_{B} = 10.5 V) beneath the barrier gate electrode, as shown in FIG. 4.

Now, if the reset clock φ_{R} reaches its high level (5 V) at a time t₁, the channel potential Ψ_{RH} beneath the reset gate electrode 8 will be 11 volts according to FIG. 2, and this level is higher than the potential V_{RD} ( = Ψ_{B} = 10.5 V) of the reset drain 9. Therefore, at this time of resetting, the reset transistor 12 is driven into an on-state of complete transfer mode, fully drains signal charges in the floating diffused region 7, and resets the potential at this diffused region 7 to the same level as the potential V_{RD} (= 10.5 V) of the reset drain region 9.

The on-state of the reset transistor 12 leads to the inflow of charges from the floating diffused region 7 to the reset drain region 9 and consequently a variation in the potential V_{RD} there, but the variation in the potential V_{RD} due to the inflow of charges can be ignored if the capacity of the capacitor C is sufficiently large.

Afterwards, at a time t₂, the reset clock Ψ_{R} drops to its low level, and at a time t₃, a signal charge 40 flows into the floating diffused region 7.

Here, the voltage variation due to the inflow charge 40 into the floating diffused region 7 is guaranteed in a range of Ψ_{B} to Ψ_{RL}, as is apparent from FIG. 4, Ψ_{RL} being the channel potential beneath the reset gate electrode 8 when the reset clock Ψ_{R} is at its low level. Now, if the low level of the reset clock Ψ_{R} is 0 V, Ψ_{B} - Ψ_{RL} will be 3.5 volts, because Ψ_{RL} is 7 volts according to FIG. 2. Since a 2 volt variation is usually considered sufficient, a wide enough dynamic range can be assured if the input voltage is 5 V.

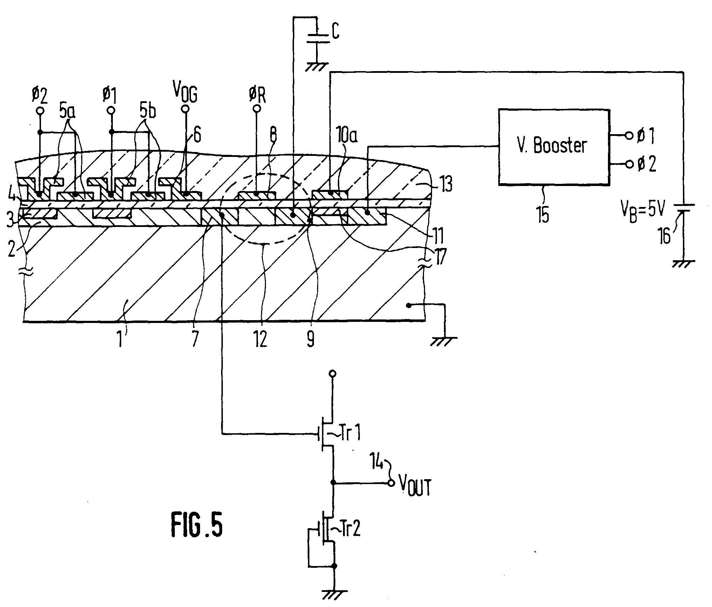

FIG. 5 shows a sectional view of a second preferred embodiment of the present invention. This embodiment differs from the first one in that the gate length of a barrier gate electrode 10a is 5 micron meters, equal to that of the reset gate electrode 8, and that a p-type barrier region 17 is formed beneath this barrier gate electrode 10a. The p-type barrier region 17 is 0.3 micron meters in depth, and its impurity concentration need not be higher than, or may be even half as high as, that of the p-type barrier region 3. At any rate, it is so arranged that the channel potential Ψ_{B} beneath the barrier gate electrode 10a is lower than the channel potential Ψ_{RH} beneath the reset gate electrode 8, which is the potential at the time when the reset clock φ_{R} is at its high level, so that charges in the floating diffused region 7 can be completely drained.

As hitherto described, the present invention makes it possible, by providing an absorption drain region via a barrier gate in a stage following the reset drain region connected to a capacitor, making the channel potential of the barrier gate lower than that under the reset gate electrode when in resetting operation, and providing a voltage booster whose output voltage is supplied to the absorption drain region, to obtain a charge transfer device free from the deterioration of the dynamic range resulting from faulty resetting of the floating diffused region even if the power voltage or the driving pulse supplied from outside is low in voltage. Since the charge transfer section may be prior art structure and requires no alteration, the voltage requirement can be lowered without entailing major redesigning.

## Claims

1. A solid-state charge transfer device comprising:
an electric charge transfer section (2) in a semiconductor substrate (1);
a floating diffused region (7) formed following said electric charge transfer section (2) in said semiconductor substrate (1);
a reset drain region (9) in the vicinity of and apart from said floating diffused region (7) in said semiconductor substrate (1);
an output gate electrode (6), provided on said semiconductor substrate (1) between said electric charge transfer section (2) and said floating diffused region (7), for controlling the inflow of electric charges from said electric charge tansfer section (2) to said floating diffused region (7); and
a reset gate electrode (8), provided on said semiconductor substrate (1) between said floating diffused region (7) and said reset drain region (9), for resetting the potential of said floating diffused region (7) to that of said reset drain region (9);
characterized by further comprising an absorption drain region (11) formed in the vicinity of and apart from said reset drain region (9) in said semiconductor substrate (1);
a barrier gate electrode (10) provided on said semiconductor substrate (1) between said reset drain region (9) and said absorption drain region (11);
a capacitor (C) inserted between said reset drain region (9) and a reference potential terminal;
a voltage booster connected to said absorption drain region (11), for raising a power voltage supplied to said solid-state charge transfer device.

2. A solid-state charge transfer device as claimed in claim 1, wherein the channel potential beneath said barrier gate electrode (10) is set lower than the channel potential under said reset gate electrode (8) when in resetting operation.

3. A solid-state charge transfer device as claimed in claim 1, wherein the gate length of said barrier gate electrode (10) is larger than the length of said reset gate electrode (8).

4. A solid-state charge transfer device as claimed in claim 1, wherein an impurity of the same conductive type as said absorption drain region (11) is introduced into said semiconductor substrate (1).

5. A solid-state charge transfer device as claimed in claim 1, wherein said semiconductor substrate (1) is a p-type silicon substrate;
transfer electrodes (5a, 5b) in said electric charge transfer section (2), said output gate electrode (6) said reset gate electrode (8) and said barrier gate electrode (10) are provided over an n-type diffused region, selectively formed over the surface of said p-type silicon substrate (1) via a gate oxide film.

6. A solid-state charge transfer device as claimed in claim 1, wherein said voltage booster (C) is a circuit for enlarging the amplitude of a transfer pulse, which is supplied from an external terminal and drives said electric charge transfer section (2).

## Patentansprüche

1. Festkörper-Ladungsübertragungsvorrichtung mit:
einem Übertragungsabschnitt (2) für elektrische Ladungen in einem Halbleitersubstrat (1),
einem Schwebediffusionsbereich (7), der dem Ladungsübertragungsabschnitt (2) für elektrische Ladungen in dem Halbleitersubstrat (1) folgend ausgebildet ist,
einem Rückstelldrainbereich (9) in der Nähe und getrennt von dem Schwebediffusionsbereich (7) in dem Halbleitersubstrat (1),
einer Ausgangsgateelektrode (6), die auf dem Halbleitersubstrat (1) zwischen dem Ladungsübertragungsabschnitt (2) für elektrische Ladungen und dem Schwebediffusionsbereich (7) ausgebildet ist, zum Steuern des Einfließens der elektrischen Ladungen von dem Übertragungsabschnitt (2) für elektrische Ladungen an den Schwebediffusionsbereich (7) und einer Rückstellgateelektrode (8), die auf dem Halbleitersubstrat (1) zwischen dem Schwebediffusionsbereich (7) und dem Rückstelldrainbereich (9) angeordnet ist, zum Rückstellen des Potentials des Schwebediffusionsbereichs (7) auf das des Rückstelldrainbereichs (9),
**gekennzeichnet** durch weiterhin einen Absorptionsdrainbereich (11), der in der Nähe und getrennt von dem Rückstelldrainbereich (9) in dem Halbleitersubstrat (1) ausgebildet ist,
eine Sperrgateelektrode (10), die auf dem Halbleitersubstrat (1) zwischen dem Rückstelldrainbereich (9) und dem Absorptionsdrainbereich (11) vorgesehen ist,
einen Kondensator (C) der zwischen dem Rückstelldrainbereich (9) und einem Bezugspotentialanschluß eingefügt ist, einen Spannungsverstärker, der mit dem Absorptionsdrainbereich (11) verbunden ist, um eine Versorgungsspannung, die der Festkörper-Ladungsübertragungsvorrichtung zugeführt wird, zu erhöhen.

2. Festkörper-Ladungsübertragungsvorrichtung nach Anspruch 1, wobei das Kanalpotential unterhalb der Sperrgateelektrode (10) niedriger als das Kanalpotential unter der Rückstellgateelektrode (8), wenn sie im Rückstellbetrieb ist, eingestellt ist.

3. Festkörper-Ladungsübertragungsvorrichtung nach Anspruch 1, wobei die Gatelänge der Sperrgateelektrode (10) größer ist als die Länge der Rückstellgateelektrode (8).

4. Festkörper-Ladungsübertragungsvorrichtung nach Anspruch 1, wobei ein Störstoff desselben Leitfähigkeitstyps wie bei dem Absorptionsdrainbereich (11) in das Halbleitersubstrat (1) eingebracht ist.

5. Festkörper-Ladungsübertragungsvorrichtung nach Anspruch 1, wobei das Halbleitersubstrat (1) ein P-Silizumsubstrat ist,
wobei Übertragungselektroden (5a, 5b) in dem Übertragungsabschnitt (2) für elektrische Ladungen, die Ausgangsgateelektrode (6), die Rückstellgateelektrode (8) und die Sperrgateelektrode (10) über einem N-Diffusionsbereich angeordnet sind, der selektiv über die Oberfläche des P-Siliziumsubstrats (1) über einem Gateoxidfilm ausgebildet ist.

6. Festkörper-Ladungsübertragungsvorrichtung nach Anspruch 1, wobei der Spannungsverstärker (C) eine Schaltung zum Vergrößern der Amplitude eines Übertragungspulses ist, der von einem externen Anschluß zugeführt wird und den Übertragungsabschnitt (2) für elektrische Ladungen treibt.

## Revendications

1. Dispositif à transfert de charges à semi-conducteur comprenant : une partie de transfert de charges électriques (2) située dans un substrat de semi-conducteur (1) ;
une région diffusée flottante (7), formée à la suite de ladite partie de transfert de charges électriques (2) dans ledit substrat de semi-conducteur (1) ;
une région de drain de réinitialisation (9) au voisinage de, et séparée de ladite région diffusée flottante (7) dans ledit substrat de semi-conducteur (1) ;
une électrode de grille de sortie (6), disposée sur ledit substrat de semi-conducteur (1), entre ladite partie de transfert de charges électriques (2) et ladite région diffusée flottante (7), pour commander l'écoulement d'entrée de charges électriques depuis ladite partie de transfert de charges électriques (2) vers ladite région diffusée flottante (7) ; et
une électrode de grille de réinitialisation (8), disposée sur ledit substrat de semi-conducteur (1), entre ladite région diffusée flottante (7) et ladite région de drain de réinitialisation (9), pour réinitialiser le potentiel de ladite région diffusée flottante (7) à celui de ladite région de drain de réinitialisation (9) ;
caractérisé par le fait qu'il comprend en outre une région de drain d'absorption (11), formée au voisinage et séparée de ladite région de drain de réinitialisation (9) dans ledit substrat de semi-conducteur (1) ;
une électrode de grille d'arrêt (10), prévue sur ledit substrat de semi-conducteur (1), entre ladite région de drain de réinitialisation (9) et ladite région de drain d'absorption (11) ;
un condensateur (C) inséré entre ladite région de drain de réinitialisation (9) et une borne de potentiel de référence ;
un élévateur de tension connecté à ladite région de drain d'absorption (11), pour élever une tension, d'alimentation délivrée audit dispositif de transfert de charges à semi-conducteur.

2. Dispositif à transfert de charges à semi-conducteur selon la revendication 1, dans lequel le potentiel de canal au-dessous de ladite électrode de grille d'arrêt (10) est fixé plus bas que le potentiel de canal sous ladite électrode de grille de réinitialisation (8), lorsqu'il est dans l'opération de réinitialisation.

3. Dispositif à transfert de charges à semi-conducteur selon la revendication 1, dans lequel la longueur de grille de ladite électrode de grille d'arrêt (10) est plus grande que la longueur de ladite électrode de grille de réinitialisation (8).

4. Dispositif à transfert de charges à semi-conducteur selon la revendication 1, dans lequel une impureté du même type conducteur que ladite région de drain d'absorption (11) est introduite dans ledit substrat de semi-conducteur (1).

5. Dispositif à transfert de charges à semi-conducteur selon la revendication 1, dans lequel ledit substrat de semi-conducteur (1) est un substrat de silicium de type p ;
des électrodes de transfert (5a, 5b) dans ladite partie de transfert de charges électriques (2), ladite électrode de grille de sortie (6), ladite électrode de grille de réinitialisation (8) et ladite électrode de grille d'arrêt (10), sont disposées sur une région diffusée de type n, formée de manière sélective sur la surface dudit substrat de silicium de type p (1), par l'intermédiaire d'un film d'oxyde de grille.

6. Dispositif à transfert de charges à semi-conducteur selon la revendication 1, dans lequel ledit élévateur de tension (C) est un circuit pour augmenter l'amplitude d'une impulsion de transfert, qui est délivrée depuis une borne externe, et commande ladite partie de transfert de charges électriques (2).
